# EUROPEAN PATENT APPLICATION

(11) **EP 2 562 831 A2**
(43) Date of publication of application: **27.02.2013**
(21) Application number: 12156822.4
(22) Date of filing: 24.02.2012
(51) Int. Cl.: H01L 33/60, H01L 33/52

(54) **Light emitting device package and lighting system**

(30) Priority: 24.08.2011 KR 20110084717
(71) Applicant: LG Innotek Co., Ltd., Seoul 100-714 (KR)
(72) Inventor: Kim, Hyun Min, 100-714 Seoul (KR)
(74) Representative: Zardi, Marco

(57) **Abstract**

Disclosed are a light emitting device package (100) and a lighting system. The light emitting device package includes a body (110) including a cavity (115), at least one light emitting device (120) in the cavity, a resin member (170) filled in the cavity while covering the light emitting device, and a reflective layer (180) on a lateral side of the cavity. The reflective layer is formed while opening the upper region of the cavity. The reflective layer is selectively formed only in a lower region of the lateral side of the cavity in the body, and the resin member, which is filled in the upper portion of the cavity, directly adheres to the body. The air-tightness between the resin member and the body is improved.

## Description

### BACKGROUND

The disclosure relates to a light emitting module.

A light emitting diode (LED) may constitute a light emitting source by using GaAs, AlGaAs, GaN, InGaN, and InGaAlP-based compound semiconductor materials.

Such an LED is packaged so as to be used as a light emitting device package that emits lights having various colors. The light emitting device package is used as a light source in various products such as a lighting indicator to represent color, a character indicator, and an image indicator.

### SUMMARY

The present invention provides a light emitting device package having a novel structure.

The present invention provides a light emitting device package capable of ensuring the adhesive strength between a resin member and a body.

According to the present invention, there is provided a light emitting device package including a body including a cavity, at least one light emitting device in the cavity, a resin member filled in the cavity while covering the light emitting device, and a reflective layer on a lateral side of the cavity. The reflective layer is formed while opening the upper region of the cavity.

As described above, according to the light emitting device package of the disclosure, the reflective layer is selectively formed only in a lower region of the lateral side of the cavity in the body, and the resin member, which is filled in an upper portion of the cavity, directly adheres to the body. Accordingly, the air-tightness between the resin member and the body can be improved.

In addition, the light emission efficiency can be improved by the reflective layer on the lateral side of the cavity.

### BRIEF DESCRIPTION OF THE DRAWINGS

FIG. 1 is a perspective view showing a light emitting device package according to a first present invention of the disclosure;

FIG. 2 is a sectional view taken along line I-I' of the light emitting device package shown in FIG. 1;

FIG. 3 is a sectional view showing the light emitting diode of FIG. 1;

FIG. 4 is a sectional view showing a light emitting device package according to a second present invention of the disclosure;

FIG. 5 is a sectional view showing a light emitting device package according to a third present invention of the disclosure;

FIG.6 is a perspective view showing a light emitting device package according to a fourth present invention of the disclosure;

FIG. 7 is a sectional view taken along line I-I' of the light emitting device package shown in FIG. 6;

FIG. 8 is a perspective view showing a light emitting device package according to a fifth present invention of the disclosure;

FIG. 9 is a perspective view showing a light emitting device package according to a fifth present invention of the disclosure;

FIG. 10 is an exploded perspective view showing the display apparatus according to the present invention; and

FIG. 11 is a perspective view showing a lighting apparatus according to the present invention.

### DETAILED DESCRIPTION OF THE PRESENT INVENTIONS

In the following description, the present inventions of the disclosure will be described in detail to the extent that those skilled in the art can readily perform the present inventions. However, the disclosure may have various modifications, and is not limited to the following present inventions.

Throughout the whole specification, when a predetermined part "includes" a predetermined component, this does not mean the exclusion of other components, but means the additional inclusion of other components.

The thickness and size of each layer shown in the drawings may be exaggerated, omitted or schematically drawn for the purpose of convenience or clarity. In addition, the size of elements does not utterly reflect an actual size. The same reference numbers will be assigned to the same elements.

In the description of the present inventions, it will be understood that, when a layer (or film), a region, a pattern, or a structure is referred to as being "on" or "under" another substrate, another layer (or film), another region, another pad, or another pattern, it can be "directly" or "indirectly" over the other substrate, layer (or film), region, pad, or pattern, or one or more intervening layers may also be present. Such a position of the layer has been described with reference to the drawings.

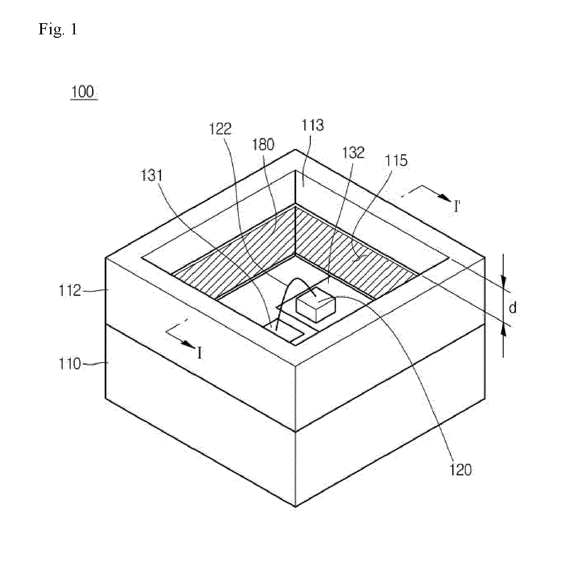

Hereinafter, a light emitting device package 100 according to a first present invention of the disclosure will be described with reference to FIGS. 1 to 3.

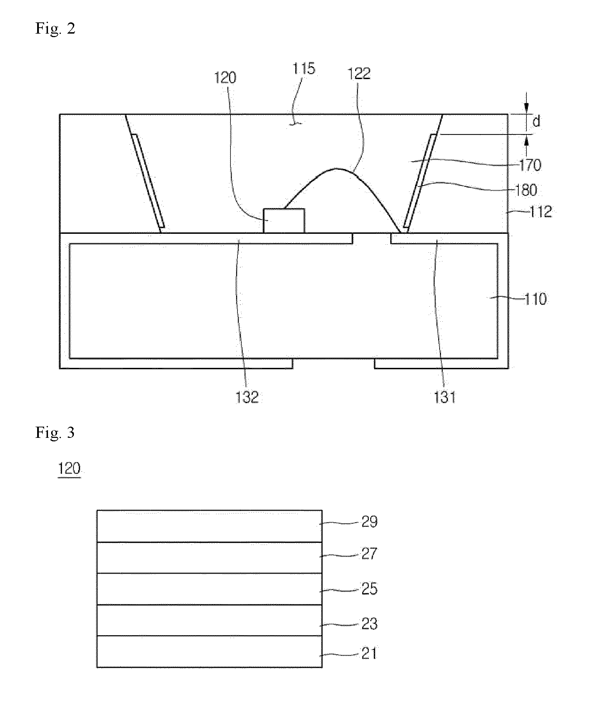

FIG. 1 is a perspective view showing the light emitting device package 100 according to the first present invention of the disclosure, FIG. 2 is a sectional view taken along line I-I' of the light emitting device package 100 shown in FIG. 1, and FIG. 3 is a sectional view showing a light emitting diode of FIG. 1.

Referring to FIGS. 1 to 3, the light emitting device package 100 includes a body 110, at least one light emitting device 120 provided on the body 110, and first and second electrodes 131 and 132 provided on the body 110 so that the first and second electrodes 131 and 132 are electrically connected to the light emitting device 120.

In addition, the light emitting device package 100 includes a resin member 170 to protect the light emitting device 120.

The body 110 may include at least one of resin material such as polyphthalamide (PPA), silicon (Si), metallic material, photo sensitive glass (PSG), sapphire (Al₂O₃), and a printed circuit board (PCB). Preferably, the body 110 may include the resin material such as PSG.

The body 110 may include a conductor having electrical conductivity. If the body 110 includes the conductor having electrical conductivity, an insulating layer (not shown) may be formed on the surface of the body 110 to prevent the body 110 from being shorted with the first and second electrodes 131 and 132. When viewed in a plan view, the circumference of the body 110 may have various shapes such as a triangular shape, a rectangular shape, a polygonal shape, and a circular shape according to the use and the design of the light emitting device package 100.

A cavity 115 may be formed in the body 112 to open an upper portion 112 of the body 110. For example, the cavity 115 may be formed through injection-molding, or through etching.

The cavity 115 may have the shape of a cup or the shape of a concave vessel. The internal lateral side of the cavity 115 may be perpendicular to a bottom surface of the cavity 115 or may be inclined. If the cavity 115 is inclined by performing a wet etching process with respect to the body 110, the cavity 115 may have an inclined angle of about 50° to about 60° .

In addition, when viewed in a plan view, the cavity 115 may have a circular shape, a rectangular shape, a polygonal shape, or an oval shape.

The first and second electrodes 131 and 132 may be formed on the body 110. The first and second electrodes 131 and 132 may be electrically divided into an anode and a cathode to supply power to the light emitting device 120. Meanwhile, in addition to the first and second electrodes 131 and 132, a plurality of electrodes may be formed on the body 110 according to the design of the light emitting device 120, but the present invention is not limited thereto.

Meanwhile, the first and second electrodes 131 and 132 are separated from each other and exposed in the cavity 115. As shown in FIG. 2, the first and second electrodes 131 and 132 may be extended to a rear surface of the body 110 while surrounding the lateral side of the body 110, but the present invention is not limited thereto.

The first and second electrodes 131 and 132 may be formed in a single structure. For example, the first and second electrodes 131 and 132 may include metal including at least one of Cu, Cr, Au, Al, Ag, Sn, Ni, Pt, and Pd, or the alloy thereof. In addition, the first and second electrodes 131 and 132 may be formed in a multiple structure. For example, the first and second electrodes 131 and 132 may include a Ti/Cu/Ni/Au layer formed by sequentially stacking titanium (Ti), copper (Cu), nickel (Ni), and gold (Au), but the present invention is not limited thereto.

In other words, material, such as Ti, Cr, or Ta, representing superior adhesive strength with the body is stacked in the lowermost layer of the first and second electrodes 131 and 132, material, such as Au, which is readily attached to a wire and the like and represents superior electrical conductivity, is stacked on the uppermost layer of the first and second electrodes 131 and 132, and a diffusion barrier layer including platinum (Pt), nickel (Ni), or copper (Cu) is stacked between the uppermost layer and the lowermost layer of the first and second electrodes 131 and 132. However, the present invention is not limited thereto.

The first and second electrodes 131 and 132 may be selectively formed through a plating scheme, a deposition scheme, or photolithography, but the present invention is not limited thereto.

In addition, the first and second electrodes 131 and 132 are attached to a wire 122 serving as a conductive connection member, so that the first and second electrodes 131 and 132 are electrically connected to the light emitting device 120.

Meanwhile, as shown in FIGS. 1 and 2, a cathode mark may be formed on the body 110 in order to distinguish between the first and second electrodes 131 and 132. However, the present invention is not limited thereto.

A reflective layer 180 may be formed on the lateral side of the cavity 115 in the body 110.

The reflective layer 180 may be made of alloy including Al, Ti, Cu, Ni, or Au.

The reflective layer 180 is formed while being spaced apart from the first and second electrodes 131 and 132 provided on the bottom surface of the cavity 115, and not formed at an upper region 113 of the lateral side of the cavity 115.

As shown in FIGS. 1 and 2, since the reflective layer 180 is not formed on the upper region 113 of the lateral side of the cavity 115, the resin member 170 may directly adhere to the body 110 at the upper region 113of the lateral side of the cavity 115.

As described above, light efficiency can be prevented from being degraded due to color change caused by the degradation of the resin member 170 constituting the body 110 if the reflective layer 180 is formed on the lateral side of the cavity 115. In addition, the reflective layer 180 is formed at a region other than the upper region 113, thereby allowing the body 110 and the resin member 170, which include similar materials to represent a superior adhesive property, to directly adhere to each other at the upper region 113, so that the air-tightness between the body 110 and the resin member 170 can be ensured.

The light emitting device 120 may be mounted on the body 110. If the body 110 includes the cavity 115, the light emitting device 120 may be mounted in the cavity 115.

At least one light emitting device 120 may be provided on the body 110 according to the design of the light emitting device package 100. If a plurality of light emitting devices 120 are mounted on the body 120, a plurality of electrodes may be formed to supply power to the light emitting device packages 100, but the present invention is not limited thereto.

The light emitting device 120 may be directly mounted on the body 110, or electrically connected to the first and second electrodes 131 and 132 on the first and second electrodes 131 and 132.

The light emitting device 120 may be mounted by selectively using a wire bonding scheme, a die bonding scheme, or a flip bonding scheme. The bonding scheme may vary according to the types of a chip and the positions of electrodes of the chip.

The light emitting device 120 may selectively include a semiconductor light emitting device manufactured by using compound semiconductors such as AlInGaN, InGaN, GaN, GaAs, InGaP, AllnGaP, InP, and InGaAs including group III-V elements.

As shown in FIG. 2, the light emitting device 120 may be attached to the second electrode 132 by using a conductive adhesive agent, and may be attached to the first electrode 131 by using the wire 122.

The light emitting device 120 is designated as a vertical light emitting device, and includes a conductive support substrate 21, a bonding layer 23, a second conductive semiconductor layer 25, an active layer 27, and a first conductive semiconductor layer 29 as shown in FIG. 3.

The conductive support substrate 21 may include metal or an electrical conductive semiconductor substrate.

A group III-V nitride semiconductor layer is formed on the conductive support substrate 21, and growth equipment for a semiconductor includes an E-beam evaporator, PVD (physical vapor deposition) equipment, CVD (chemical vapor deposition) equipment, PLD (plasma laser deposition) equipment, a dual-type thermal evaporator, sputtering equipment, or MOCVD (metal organic chemical vapor deposition) equipment, but the present invention is not limited thereto.

The bonding layer 23 may be formed on the conductive support substrate 21. The bonding layer 23 bonds the conductive support substrate 21 with a nitride semiconductor layer. In addition, the conductive support substrate 21 may be formed through a plating scheme instead of a bonding scheme. In this case, the bonding layer 23 may not be formed.

The second conductive semiconductor layer 25 may be formed on the bonding layer 23. The second conductive semiconductor layer 25 may be electrically connected to the first electrode 31.

The second conductive semiconductor layer 25 may include a group III-V compound semiconductor. For example, the second conductive semiconductor layer 25 may include at least one selected from the group consisting of GaN, InN, AIN, InGaN, AIGaN, InAIGaN, and AlInN. The second conductive semiconductor layer 25 may be doped with second conductive dopants. The second conductive dopants include P type dopants such as Mg, Zn, Ca, Sr, and Ba.

The second conductive semiconductor layer 25 may include a P type GaN layer formed at a predetermined thickness by supplying gas including P type dopants such as NH3, TMGa (or TEGa), or Mg.

The second conductive semiconductor layer 25 includes a current spreading structure at a predetermined region. The current spreading structure includes semiconductor layers representing a current spreading speed in a horizontal direction faster than a current spreading speed in a vertical direction.

For example, the current spreading structure may include semiconductor layers making differences in the concentration of dopants or the conductivity of the dopants.

The second conductive semiconductor layer 25 supplies carriers spread in uniform distribution to another layer thereon, for example, the active layer 27.

The active layer 27 is formed on the second conductive semiconductor layer 25. The active layer 27 has a single quantum well structure (SQW) or a multi-quantum well structure (MQW). One stack structure of the active layer 27 may selectively include an InGaN/GaN stack structure, an AlGaN/InGaN stack structure, an InGaN/InGaN stack structure, or an AIGaN/GaN stack structure.

A second conductive clad layer (not shown) may be formed between the second conductive semiconductor layer 25 and the active layer 27. The second conductive clad layer may include a P type GaN semiconductor. The second conductive clad layer may include a material having an energy bandgap higher than that of the well layer.

The first conductive semiconductor layer 29 is formed on the active layer 27. The first conductive semiconductor layer 29 may include an N type semiconductor layer doped with first conductive dopants. The N type semiconductor layer may include one of compound semiconductors such as GaN, InN, AIN, InGaN, AlGaN, InAlGaN, and AlInN. The first conductive dopant is an N type dopant, and may include at least one of Si, Ge, Sn, Se, and Te.

The first conductive semiconductor layer 29 may include an N type GaN layer formed at a predetermined thickness by supplying gas including an N type dopant such as NH3, TMGa (or TEGa), or Si.

In addition, the second conductive semiconductor layer 25 may include a P type semiconductor layer, and the first conductive semiconductor layer 29 may include an N type semiconductor layer. A light emitting structure may include one of an N-P junction structure, a P-N junction structure, an N-P-N junction structure, and a P-N-P junction structure. Hereinafter, a case in which the uppermost layer of the semiconductor layer is the first conductive semiconductor layer 29 will be described for the illustrative purpose.

The first electrode 131 and/or an electrode layer (not shown) may be formed on the first conductive semiconductor layer 29. The electrode layer may include an oxide or nitride-based transmissive layer. For example, the electrode layer may include one selected from the group consisting of ITO (indium tin oxide), ITON (indium tin oxide nitride), IZO (indium zinc oxide), IZON (indium zinc oxide nitride), IZTO (indium zinc tin oxide), IAZO (indium aluminum zinc oxide), IGZO (indium gallium zinc oxide), IGTO (indium gallium tin oxide), AZO (aluminum zinc oxide), ATO (antimony tin oxide), GZO (gallium zinc oxide), IrOx, RuOx, and NiO. The electrode layer may serve as a current spreading layer capable of spreading a current.

In addition, the electrode layer may include a reflective electrode layer. The reflective electrode layer may include a material selected from the group consisting of Ag, Ni, Al, Rh, Pd, Ir, Ru, Mg, Zn, Pt, Au, Hf, and the selective combination thereof. The first electrode may include a metallic layer in a single layer structure or a multiple layer structure. For example, the metallic layer may include at least one material selected from the group consisting of Ag, Ni, Al, Rh, Pd, Ir, Ru, Mg, Zn, Pt, Au, and Hf, or the alloy thereof.

A plurality of the light emitting devices 120 may be mounted on the body 110.

In addition, the resin member 170 is formed in the cavity 115 such that the cavity 115 is filled with the resin member 170.

The resin member 170 includes material representing transmittance, and is formed to the upper portion of the body 110.

The resin member 170 has a structure in which fluorescent substances are distributed in transmissive resin. The fluorescent substances change the wavelength of light emitted from the light emitting device 120 and emit light having a different wavelength.

As described above, the resin member 170 directly adheres to the body 110 at the upper region 113 of the cavity 115, so that the air tightness between the body 110 and the resin member 170 can be ensured to block the inflow of external moisture and external air.

For example, when the light emitting device 120 is a blue light emitting diode, and the fluorescent substance represents a yellow color, the yellow fluorescent substance is excited by the blue light to generate white light. When the light emitting device 120 radiates an ultraviolet ray, fluorescent substances representing three colors of red, green, and blue are added to realize white light.

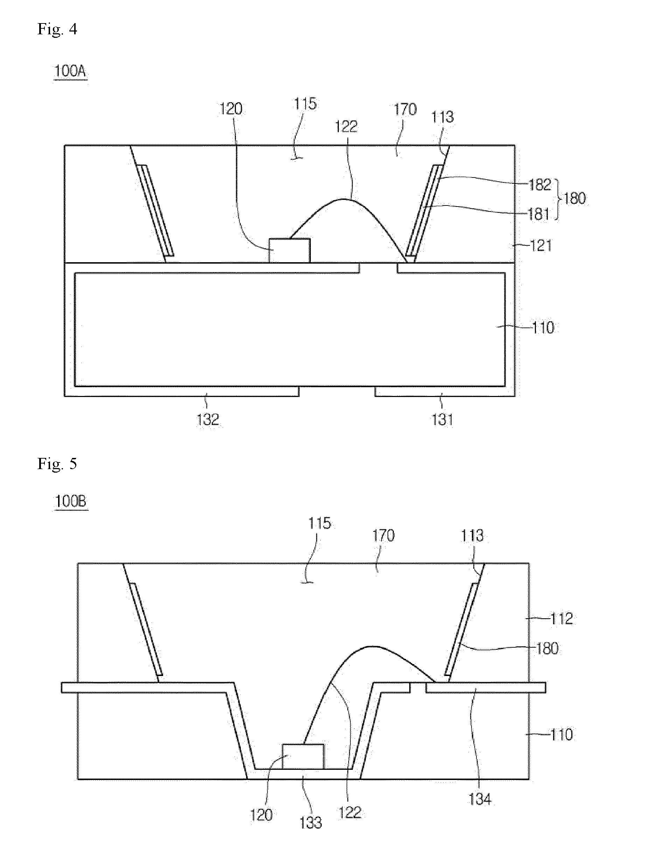

Hereinafter, another present invention of the disclosure will be described with reference to FIGS. 4 and 5.

Referring to FIG 4, a light emitting device package 100A includes the body 110, at least one light emitting device 120 provided on the body 110, and first and second electrodes 131 and 132 provided on the body 110 so that the first and second electrodes 131 and 132 are electrically connected to the light emitting device 120.

In addition, the light emitting device package 100A includes the resin member 170 to protect the light emitting device 120.

The body 110 may include at least one of resin material such as polyphthalamide (PPA), silicon (Si), metallic material, photo sensitive glass (PSG), sapphire (Al₂O₃), and a printed circuit board (PCB). Preferably, the body 110 may include the resin material such as PSG.

The body 110 may include a conductor having electrical conductivity. If the body 110 includes the conductor having electrical conductivity, an insulating layer (not shown) may be formed on the surface of the body 110 to prevent the body 110 from being shorted with the first and second electrodes 131 and 132. When viewed in a plan view, the circumference of the body 110 may have various shapes such as a triangular shape, a rectangular shape, a polygonal shape, and a circular shape according to the use and the design of the light emitting device package 100.

The cavity 115 may be formed in the body 110 to open an upper portion 112 of the body 110. For example, the cavity 115 may be formed through inj ection-molding, or through etching.

The cavity 115 may have the shape of a cup or the shape of a concave vessel. The internal lateral side of the cavity 115 may be perpendicular to a bottom surface of the cavity 115 or may be inclined. If the cavity 115 is inclined by performing a wet etching process with respect to the body 110, the cavity 115 may have an inclined angle of about 50° to about 60°.

In addition, when viewed in a plan view, the cavity 115 may have a circular shape, a rectangular shape, a polygonal shape, or an oval shape.

The first and second electrodes 131 and 132 may be formed on the body 110. The first and second electrodes 131 and 132 may be electrically divided into an anode and a cathode to supply power to the light emitting device 120. Meanwhile, in addition to the first and second electrodes 131 and 132, a plurality of electrodes may be formed on the body 110 according to the design of the light emitting device 120, but the present invention is not limited thereto.

Meanwhile, the first and second electrodes 131 and 132 are separated from each other and exposed in the cavity 115. As shown in FIG. 2, the first and second electrodes 131 and 132 may be extended to the rear surface of the body 110 while surrounding the lateral side of the body 110, but the present invention is not limited thereto.

The first and second electrodes 131 and 132 may be formed in a single structure. For example, the first and second electrodes 131 and 132 may include metal including at least one of Cu, Cr, Au, Al, Ag, Sn, Ni, Pt, and Pd, or the alloy thereof

In addition, the first and second electrodes 131 and 132 may be formed in a multiple structure. For example, the first and second electrodes 131 and 132 may include a Ti/Cu/Ni/Au layer formed by sequentially stacking Ti, Cu, Ni, and Au, but the present invention is not limited thereto.

In other words, material, such as Ti, Cr, or Ta, representing superior adhesive strength with the body is stacked in the lowermost layer of the first and second electrodes 131 and 132, material, such as Au, which is readily attached to a wire and the like and represents superior electrical conductivity, is stacked on the uppermost layer of the first and second electrodes 131 and 132, and the diffusion barrier layer including Pt, Ni, or Cu may be stacked between the uppermost layer and the lowermost layer of the first and second electrodes 131 and 132. However, the present invention is not limited thereto.

The first and second electrodes 131 and 132 may be selectively formed through a plating scheme, a deposition scheme, or photolithography, but the present invention is not limited thereto.

In addition, the first and second electrodes 131 and 132 are attached to the wire 122 serving as a conductive connection member, so that the first and second electrodes 131 and 132 are electrically connected to the light emitting device 120.

Meanwhile, as shown in FIGS. 1 and 2, a cathode mark may be formed on the body 110 in order to distinguish between the first and second electrodes 131 and 132. However, the present invention is not limited thereto.

The reflective layer 180 may be formed on the lateral side of the cavity 115 in the body 110.

The reflective layer 180 may include a seed layer 182 and an Ag-plated layer 181.

The seed layer 182 includes metallic material representing a superior adhesive property with respect to the body 110. The seed layer 182 may include alloy of Al, Ti, Cu, Ni, Au, Pt, or Rh.

The Ag-plated layer 181 is formed on the seed layer 182.

When the Ag-plated layer 181 is formed, the Ag-plated layer 181 may be formed by performing an electroplating process using the seed layer 182 as a seed.

When the Ag-plated layer 181 is formed, a predetermined pattern may be formed on the surface of the Ag-plated layer 181 or patterns may be irregularly formed on the surface of the Ag-plated layer 181. However, the present invention is not limited thereto. In addition, light emission efficiency can be improved due to the light scattering caused by the pattern. The pattern may have a convex shape such as a protrusion or a concave shape, but the present invention is not limited thereto. The pattern may have one of a semi-circular shape or a polygonal shape such as a triangular shape or a rectangular shape, but the present invention is not limited thereto.

The reflective layer 180 is formed while being spaced apart from the first and second electrodes 131 and 132 provided on the bottom surface of the cavity 115, and not formed at the upper region 113 of the lateral side of the cavity 115.

As shown in FIGS. 1 and 2, since the reflective layer 180 is not formed on the upper region 113 of the lateral side of the cavity 115, the resin member 170 may directly adhere to the body 110 at the upper region 113of the lateral side of the cavity 115.

As described above, light efficiency can be prevented from being degraded due to color change caused by the degradation of resin member constituting the body 110 if the reflective layer 180 is formed on the lateral side of the cavity 115. In addition, the reflective layer 180 is formed at a region other than the upper region 113, thereby allowing the body 110 and the resin member 170, which include similar materials to represent a superior adhesive property, to directly adhere to each other at the upper region 113, so that the air tightness between the body 110 and the resin member 170 can be ensured.

The light emitting device 120 may be mounted on the body 110. If the body 110 includes the cavity 115, the light emitting device 120 may be mounted in the cavity 115.

At least one light emitting device 120 may be mounted on the body 110 according to the design of the light emitting device package 100. If a plurality of the light emitting devices 120 are mounted on the body 120, a plurality of electrodes may be formed to supply power to the light emitting device packages 100, but the present invention is not limited thereto.

The light emitting device 120 may be directly mounted on the body 110, or electrically connected to the first and second electrodes 131 and 132 on the first and second electrodes 131 and 132.

The light emitting device 120 may be mounted by selectively using a wire bonding scheme, a die bonding scheme, or a flip bonding scheme. The bonding scheme may vary according to the types of a chip and the positions of electrodes of the chip.

A plurality of the light emitting devices 120 may be mounted on the body 110.
The resin member 170 is formed in the cavity 115 such that the cavity 115 is filled with the resin member 170.

The resin member 170 includes material representing transmittance, and is formed to the upper portion of the body 110.

The resin member 170 has a structure in which fluorescent substances are distributed in transmissive resin. The fluorescent substances change the wavelength of light emitted from the light emitting device 120 and emit light having a different wavelength.

As described above, the resin member 170 directly adheres to the body 110 at the upper region 113 of the cavity 115, so that the air tightness between the body 110 and the resin member 170 can be ensured to block the inflow of external moisture and external air.

For example, when the light emitting device 120 is a blue light emitting diode, and the fluorescent substance represents a yellow color, the yellow fluorescent substance is excited by the blue light to generate white light. When the light emitting device 120 radiates an ultraviolet ray, fluorescent substances representing three colors of red, green, and blue are added to realize white light.

Meanwhile, since the body 110, the light emitting device 120, and the reflective layer 180 shown in FIG. 5 have the same structure as those of the prior present invention, the detail thereof will be omitted.

As shown in FIG. 5, a first electrode 133 includes a receiving part to receive the light emitting device 120. The receiving part is recessed toward the bottom surface of the body 110, and a top surface of the receiving part may have a circular shape, a rectangular shape, or an oval shape.

As shown in FIG. 5, light emission efficiency can be improved by the reflective layer 180 formed in the light emitting device package 100B, which includes the first electrode 133 having the receiving part, while being spaced apart from the first and second electrodes 133 and 134.

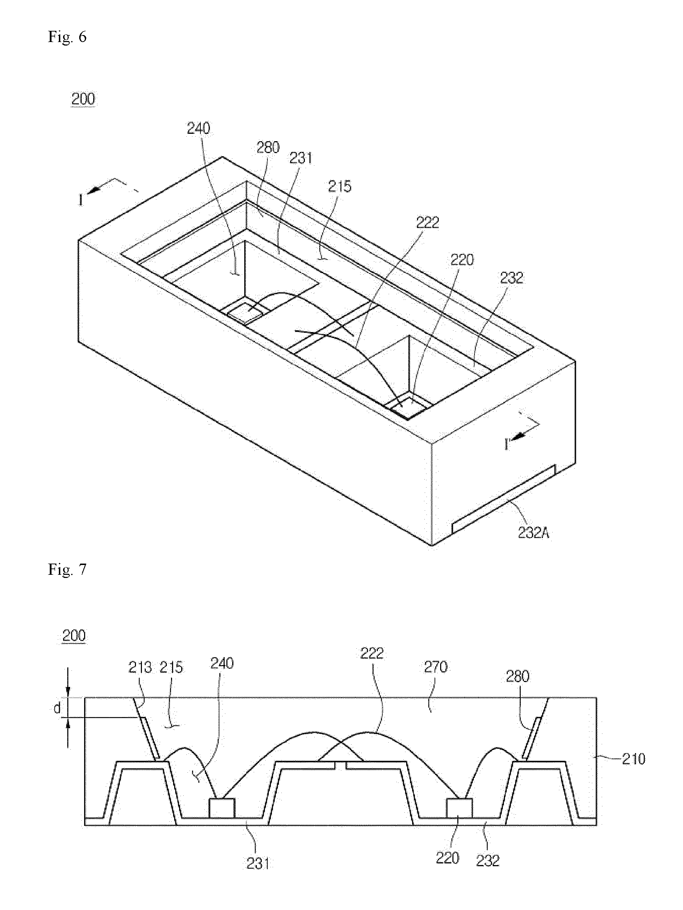

Hereinafter, another present invention of the present invention will be described with reference to FIGS. 6 and 7.

Referring to FIGS. 6 and 7, a light emitting device package 200 includes a body 210, a first lead frame 231 and a second lead frame 232 having a cavity 240, a plurality of light emitting devices 220, and wires 222.

The body 210 may include at least one of resin material such as polyphthalamide (PPA), silicon (Si), metallic material, photo sensitive glass (PSG), sapphire (Al2O3), and a printed circuit board (PCB). Preferably, the body 210 may include the resin material such as PPA.

The body 210 may include a conductor having electrical conductivity. If the body 210 includes the conductor having electrical conductivity, an insulating layer (not shown) may be formed on the surface of the body 210 to prevent the body 210 from being shorted with the first and second lead frames 231 and 232. When viewed in a plan view, the circumference of the body 210 may have various shapes such as a triangular shape, a rectangular shape, a polygonal shape, and a circular shape according to the use and the design of the light emitting device package 100.

The body 210 is provided at an upper portion therein with an open region 215 to discharge light.

The second lead frame 231 includes the cavity 240. The cavity 240 has a shape recessed from a top surface of the second lead frame 231, for example, a cup structure or a recess shape. The lateral side of the cavity 240 may be inclined with respect to the bottom surface of the cavity 240 or may be perpendicularly bended with respect to the bottom surface of the cavity 240.

The second lead frame 232 includes the cavity 240, and has the same structure as the first lead frame 231.

The cavity 240 of the first and second lead frames 231 and 232 is provided below the open region 215.

At least one light emitting device 220 is provided in the cavity 240, and attached to the bottom surface of the cavity 240. The light emitting device 220 is connected to the first and second lead frames 231 and 232 by the wires 222, respectively. The light emitting device 220 may selectively emit light from an ultraviolet wavelength band to a visible wavelength band. The light emitting device 220 may emit light representing the same peak wavelength, or light representing different peak wavelengths. The light emitting device 220 may include at least one of LED chips based on group III-V compound semiconductors, for example, an ultraviolet (UV) LED chip, a blue LED chip, a green LED chip, a white LED chip, and a red LED chip.

The bottom surfaces of the first and second lead frames 231 and 232 are provided on the bottom surface of the body 220. The bottom surfaces of the first and second lead frames 231 and 232 are connected to a pad on a board through a connection member such as a solder to serve as a heat dissipation plate.

A reflective layer 280 may be formed on the lateral side of the open region 215 in the body 210.

The reflective layer 280 may be made of alloy including Al, Ti, Cu, Ni, Au, Pt, or Rh.

The reflective layer 280 is formed while being spaced apart from the first and second lead frames 231 and 232 provided on the bottom surface of the open region 215, and not formed at an upper portion 213 of the lateral side of the open region 215.

As shown in FIGS. 6 and 7, since the reflective layer 280 is not formed on the upper region 213 of the lateral side of the open region 215, a resin member 270 adheres with the body 210 at the upper region 213 of the lateral side of the open region 215.

As described above, light efficiency can be prevented from being degraded due to color change caused by the degradation of resin member constituting the body 210 if the reflective layer 280 is formed on the lateral side of the open region 215. In addition, the reflective layer 280 is formed at a region other than the upper region 213, thereby allowing the body 210 and the resin member 270, which are made of similar materials to represent a superior adhesive property, to directly adhere to each other at the upper region 213, so that the air tightness between the body 210 and the resin member 270 can be ensured.

As shown in FIGS. 6 and 7, the resin member 270 is formed to cover the cavity 240.

The resin member 270 may be formed by dispensing transmissive materials, but the present invention is not limited thereto.

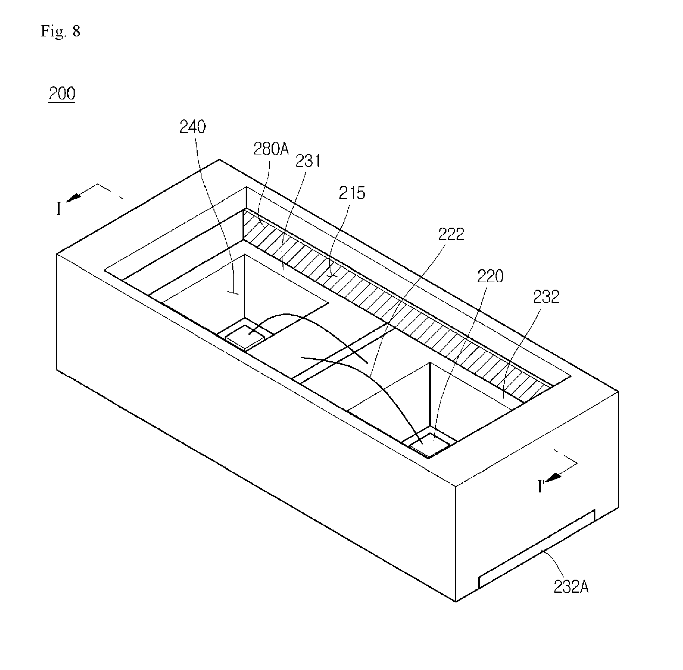

Hereinafter, still another present invention of the present invention will be described with reference to FIG. 8.

The light emitting device package 200A includes the body 210, the first lead frame 231 and the second lead frame 232 having the cavity 240, a plurality of the light emitting devices 220, and the wires 222.

The body 210 may include at least one of resin material such as polyphthalamide (PPA), silicon (Si), metallic material, photo sensitive glass (PSG), sapphire (Al₂O₃), and a printed circuit board (PCB). Preferably, the body 210 may include the resin material such as PPA.

The body 210 may include a conductor having electrical conductivity. If the body 210 includes the conductor having electrical conductivity, an insulating layer (not shown) may be formed on the surface of the body 210 to prevent the body 210 from being shorted with the first and second lead frames 231 and 232. When viewed in a plan view, the circumference of the body 210 may have various shapes such as a triangular shape, a rectangular shape, a polygonal shape, and a circular shape according to the use and the design of the light emitting device package 100.

The body 210 is provided at an upper portion therein with the open region 215 to discharge light.

The second lead frame 231 includes the cavity 240. The cavity 240 has a shape recessed from a top surface of the second lead frame 231, for example, a cup structure or a recess shape. The lateral side of the cavity 240 may be inclined with respect to the bottom surface of the cavity 240 or may be perpendicularly bended with respect to the bottom surface of the cavity 240.

The second lead frame 232 includes the cavity 240, and has the same structure as the first lead frame 231.

The cavity 240 of the first and second lead frames 231 and 232 is provided below the open region 215.

At least one light emitting device 220 is provided in the cavity 240, and attached to the bottom surface of the cavity 240. The light emitting device 220 is connected to the first and second lead frames 231 and 232 by the wire 222. The light emitting device 220 may selectively emit light from an UV wavelength band to a visible wavelength band. The light emitting device 220 may emit light representing the same peak wavelength, or light representing different peak wavelengths. The light emitting device 220 may include at least one of LED chips based on group III-V compound semiconductors, for example, an ultraviolet LED chip, a blue LED chip, a green LED chip, a white LED chip, and a red LED chip.

The bottom surfaces of the first and second lead frames 231 and 232 are provided on the bottom surface of the body 220. The bottom surfaces of the first and second lead frames 231 and 232 are connected to a pad on a board through a connection member such as a solder to serve as a heat dissipation plate.

A reflective layer 280A may be formed on the lateral side of the open region 215 in the body 210.

When a top surface of the open region 215 has a rectangular shape as shown in FIG. 8, the open region 215 has two longer sides facing each other and two shorter sides adjacent to the longer sides.

Each longer side is extended in a direction in which two light emitting devices 220 are arranged in parallel to each other.

The reflective layer 280A is formed only on a portion of the upper region 215, preferably, on the longer side.

The reflective layer 280A formed on the longer side is formed while being spaced apart from the first and second electrodes 231 and 232 provided on the bottom surface of the open region 215, and not formed at the upper portion 213 of the lateral side of the open region 215.

The reflective layer 280A is higher than the light emitting device 220.

As shown in FIG. 8, since the reflective layer 280A is not formed on the upper region 213 of the lateral side of the open region 215, the resin member 270 adheres to the body 210 at the upper portion 213 of the lateral side of the open region 215.

As described above, light efficiency can be prevented from being degraded due to color change caused by the degradation of resin member constituting the body 210 if the reflective layer 280A is formed on the lateral side of the open region 215. In addition, the reflective layer 280A is formed at a region other than the upper region 213, thereby allowing the body 210 and the resin member 270, which include similar materials to represent a superior adhesive property, to directly adhere to each other at the upper region 213, so that the air tightness between the body 210 and the resin member 270 can be ensured.

As shown in FIG.8, the resin member 270 is formed to cover the cavity 240.

The resin member 270 may be formed by dispensing transmissive materials, but the present invention is not limited thereto.

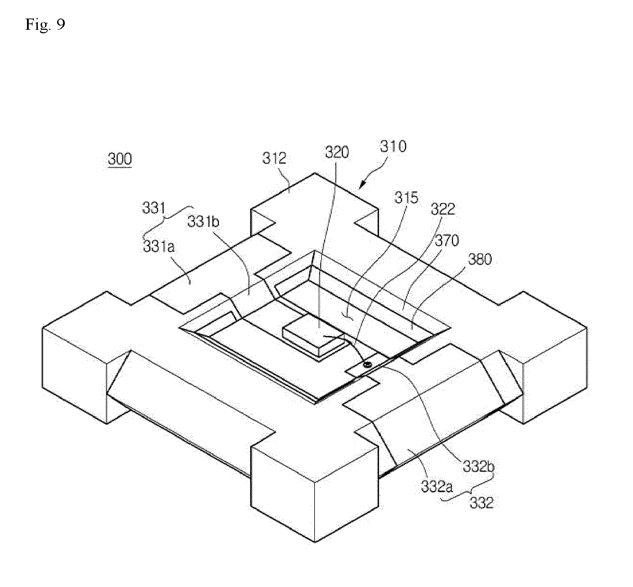

Hereinafter, still another present invention of the present invention will be described with reference to FIG. 9.

A light emitting device package 300 includes a body 310, an insulating layer 312 made of silicon oxide (SiₓO_{y}) on the surface of the body 310, at least one light emitting device 320 provided on the body 310, and first and second electrodes 331 and 332 provided on the body 310 and electrically connected to the light emitting device 320.

The body 310 may include a silicon (Si) body manufactured in a wafer level package (WLP) in which the cavity 315 is formed in a silicon wafer, the light emitting device 320 is installed in the cavity 315, and the light emitting device 320 is packaged.

The cavity 315 may be formed in the body 310 to open an upper portion of the body 310. For example, the cavity 315 may be formed through an injection molding scheme or an etching scheme.

The cavity 315 may have the shape of a cup or the shape of a concave vessel. The internal lateral side of the cavity 315 may be perpendicular to a bottom surface of the cavity 315 or may be inclined with respect to the bottom surface of the cavity 315. If the cavity 315 is inclined by performing a wet etching process with respect to the body 310 including silicon (Si), the cavity 315 may have an inclined angle of about 50° to about 60°.

In addition, when viewed in a plan view, the cavity 315 may have a circular shape, a rectangular shape, a polygonal shape, or an oval shape.

The insulating layer 312 may be formed on the surface of the body 310.

The insulating layer 312 prevents the body 310 from being shorted with the first and second electrodes 331 and 332 due to the external power.

For example, the insulating layer 312 may include at least one selected from the group consisting of Si0₂, SiₓO_{y}, Si₃N₄, SiₓN_{y}, SiOₓN_{y}, and Al₂O₃. Preferably, the insulating layer 312 may include silicon oxide (SiO₂, SiₓO_{y}), but the present invention is not limited thereto.

If the body 310 is made of Si, the insulating layer 312 may be provided in the form of a silicon oxide film through a thermal oxidation scheme. In addition, the insulating layer 312 may be deposited through a sputtering scheme, a PECVD (Plasma Enhanced Chemical Vapor Deposition) scheme, or an electronic-beam deposition scheme, but the present invention is not limited thereto.

In addition, the insulating layer 312 may be formed on the whole surface of the body 310, or may be formed in at least a region for the first and second electrodes 331 and 332. However, the present invention is not limited thereto.

The first and second electrodes 331 and 332 may be formed on the insulating layer 312. The first and second electrodes 331 and 332 may be electrically divided into an anode and a cathode to supply power to the light emitting device 120. Meanwhile, in addition to the first and second electrodes 331 and 332, a plurality of electrodes may be formed according to the design of the light emitting device 320, but the present invention is not limited thereto.

The first and second electrodes 331 and 332 may be formed in a single structure. For example, the first and second electrodes 331 and 332 may include metal including at least one of Cu, Cr, Au, Al, Ag, Sn, Ni, Pt, and Pd, or the alloy thereof.

In addition, the first and second electrodes 331 and 332 may be formed in a multiple structure. For example, the first and second electrodes 331 and 332 may include a Ti/Cu/Ni/Au layer formed by sequentially stacking titanium (Ti), copper (Cu), nickel (Ni), and gold (Au), but the present invention is not limited thereto.

In other words, material, such as Ti, Cr, or Ta, representing superior adhesive strength with respect to the insulating layer 312 is stacked in the lowermost layer of the first and second electrodes 331 and 332, material, such as Au, which is readily attached to a wire and the like and represents superior electrical conductivity, is stacked on the uppermost layer of the first and second electrodes 331 and 332, and a diffusion barrier layer including Pt, Ni, or Cu is stacked between the uppermost layer and the lowermost layer of the first and second electrodes 331 and 332. However, the present invention is not limited thereto.

The first and second electrodes 331 and 332 may be selectively formed through a plating scheme, a deposition scheme, or photolithography, but the present invention is not limited thereto.

In addition, the first and second electrodes 331 and 332 may include electrode body parts 331a and 332a and extension parts 331b and 332b protruding from the electrode body parts 331a and 32b. Widths of the extension parts 331b and 332b may be smaller than widths of the electrode body parts 331a and 332b, and only the extension parts 331b and 332b may be provided in the cavity 315 of the body 310. In addition, the extension parts 331b and 332b are bonded with a wire 322, so that the first and second electrodes 331 and 332 can be electrically connected to the light emitting device 320.

The reflective layer 380 may be spaced apart from the insulating layer 312 formed on the top surface of the body 310, the first electrode 331 and the second electrode 332.

The reflective layer 380 is formed on the lateral side of the cavity 315 of the body 310.

The reflective layer 380 may include the alloy of Al, Ti, Cu, Ni, and Au.

The reflective layer 380 is formed while being spaced apart from the first and second electrodes 331 and 332 provided on the bottom surface of the cavity 315, and not formed at the upper portion of the lateral side of the cavity 315.

Since the reflective layer 380 is not formed on the upper region of the lateral side of the cavity 315, a molding member 370 may be directly attached to the body 310 at the upper portion of the lateral side of the cavity 315.

The light emitting device 320 may be mounted on the body 310. If the body 310 includes the cavity 315, the light emitting device 320 may be mounted in the cavity 315.

The light emitting device 320 may be directly mounted on the insulating layer 312 of the body 310, or may be electrically connected to the first or second electrode 331 or 332 on the first or second electrode 331 or 332.

The light emitting device 320 may be mounted by selectively using a wire bonding scheme, a die bonding scheme, or a flip bonding scheme. The bonding scheme may vary according to the type of a chip and the position of electrodes of the chip.

A plurality of the light emitting devices 320 may be mounted on the body 310.

The light emitting device 320 may be electrically connected to the extension part 331b of the first electrode 331 on the extension part 331b of the first electrode 331, and may be electrically connected to the second electrode 332 by the wire 322.

For example, the wire 322 has one end bonded with the extension part 332b of the second electrode 332 and an opposite end bonded with the light emitting device 320. However, the present invention is not limited thereto.

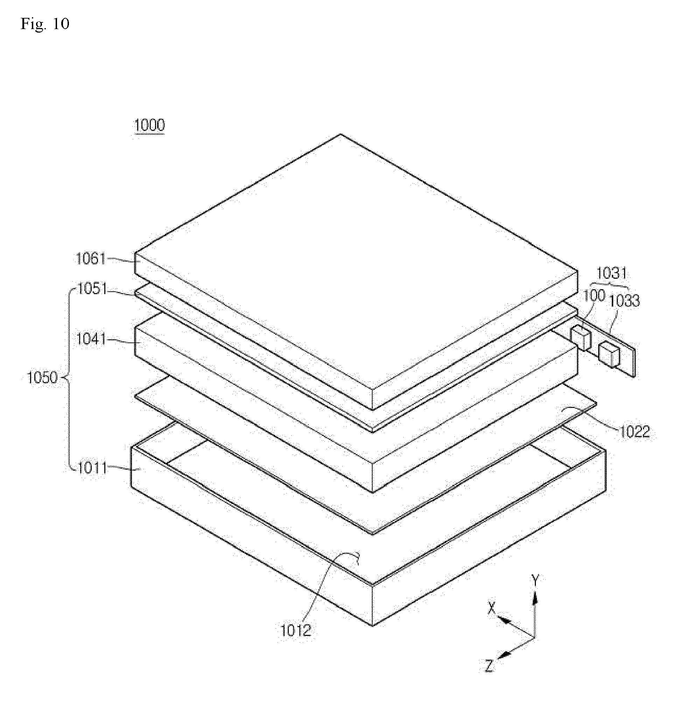

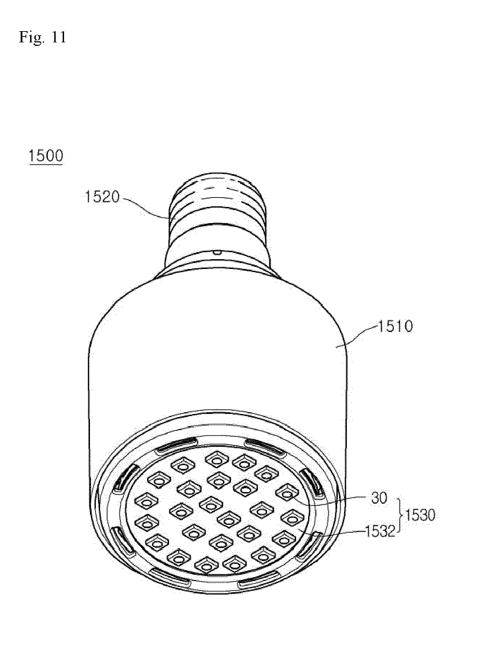

The light emitting device package according to the present invention is applicable to a light unit. The lighting unit includes a structure in which a plurality of light emitting device packages are arrayed. The light unit includes a display apparatus shown in FIG. 10 and a lighting apparatus shown in FIG. 11, and is applicable to a unit such as an illumination lamp, a signal lamp, a headlight of a vehicle, an electric sign board, and an indicator.

FIG. 10 is an exploded perspective view showing a display apparatus 1000 according to the present invention.

Referring to FIG. 10, the display apparatus 1000 includes a light guide plate 1041, a light emitting module 1031 to supply a light to the light guide plate 1041, a reflective member 1022 provided under the light guide plate 1041, an optical sheet 1051 provided above the light guide plate 1041, a display panel 1051 provided above the optical sheet 1051, and a bottom cover 1011 to receive the light guide plate 1041, the light emitting module 1031, and the reflective plate 1022, but the present invention is not limited thereto.

The bottom cover 1011, the reflective plate 1022, the light guide plate 1041, and the optical sheet 1051 may be defined as a light unit 1050.

The light guide plate 1041 diffuses light, which is supplied from a light emitting module 1031, to supply surface light. The light guide plate 1041 includes a transparent material. For example, the light guide plate 1041 may include one selected from the group consisting of acryl-based resin, such as PMMA (polymethyl methacrylate), PET (polyethylene terephthalate), PC (polycarbonate), COC (cycloolefin copolymer) and PEN (polyethylene naphthalate) resin.

The light emitting module 1031 provided on at least one lateral side of the light guide plate 1041 to supply a light to the at least one lateral side of the light guide plate 1041. Accordingly, the light emitting module 1031 serves as a light source of the display apparatus 1000.

At least one light emitting module 1031 is provided, and directly or indirectly supplies light at one lateral side of the light guide plate 1041. The light emitting module 1031 includes a substrate 1033 and the disclosed light emitting device package 100 according to the present invention. The light emitting device package 100 may be arranged at a predetermined distance on the substrate 1033. The substrate 1033 may include a printed circuit board, but the present invention is not limited thereto. In addition, the substrate 1033 may include a metal core PCB (Metal Core PCB), or a flexible PCB (FPCB), but the present invention is not limited thereto. If the light emitting device package 100 is mounted on the lateral side of the bottom cover 1011 or a heat dissipation plate, the substrate 1033 may be removed. A portion of the heat dissipation plate may make contact with the top surface of the bottom cover 1011. Therefore, heat generated from the light emitting device package 100 may be discharged to the bottom cover 1011 through the heat dissipation plate.

In the light emitting device packages 100, light exit surfaces to discharge light are spaced apart from the light guide plate 1041 by a predetermined distance on the substrate 1033, but the present invention is not limited thereto. The light emitting device package 100 can directly or indirectly supply light to a light incidence part which is one lateral side of the light guide plate 1041, but the present invention is not limited thereto.

The reflective member 1022 may be provided under the light guide plate 1041. The reflective plate 1022 reflects a light, which is incident from the bottom surface of the light guide plate 1041, upward to supply the light to the display panel 1061, so that the brightness of the light unit 1050 can be improved. The reflective member 1022 may include PET, PC, or PVC resin, but the present invention is not limited thereto. The reflective member 1022 may serve as a top surface of the bottom cover 1011, but the present invention is not limited thereto.

The bottom cover 1011 may receive the light guide plate 1041, the light emitting module 1031, and the reflective member 1022. To this end, the bottom cover 1011 may include a receiving part 1012 having the shape of a box having an open upper portion, but the present invention is not limited thereto. The bottom cover 1011 may be coupled with a top cover (not shown), but the present invention is not limited thereto.

The bottom cover 101 may include a metallic material or a resin material, and may be manufactured through a press molding process or an extrusion molding process. The bottom cover 1011 may include a metallic material or a non-metallic material representing superior thermal conductivity, but the present invention is not limited thereto.

The display panel 1061, for instance, is an LCD panel including first and second transparent substrates, which are opposite to each other, and a liquid crystal layer interposed between the first and second substrates. A polarizing plate can be attached to at least one surface of the display panel 1061, but the present invention is not limited thereto. The display panel 1061 displays information by allowing a light to pass through the light emitting module 1031 or to be blocked. The display device 1000 is applicable to various portable terminals, a monitor of a laptop computer, or an image display apparatus such as a television.

The optical sheet 1051 is interposed between the display panel 1061 and the light guide plate 1041, and includes at least one transmissive sheet. The optical sheet 1051 may include at least one sheet of a diffusion sheet, a horizontal/vertical prism sheet, and a brightness enhancement film. The diffusion sheet diffuses the incident light, the horizontal/vertical prism sheet concentrates the incident light onto the display panel 1061, and the brightness enhancement sheet improves the brightness of light by reusing the wasted light. In addition, a protective sheet may be provided on the display panel 1061, but the present invention is not limited thereto.

The light guide plate 1041 and the optical sheet 1051 may serve as optical members on the optical path of the light emitting module 1031, but the present invention is not limited thereto.

FIG. 11 is a perspective view showing a lighting apparatus 1500 according to the present invention.

Referring to FIG. 11, the lighting apparatus 1500 includes a case 1510, a light emitting module 1530 installed in the case 1510, the optical member on the optical path of the light emitting module 1031, and a connection terminal 1520 installed in the case 1510 to receive power from an external power source.

The optical member includes an optical sheet (not shown) positioned at an end portion of the case 1510 and including a cover in which the light emitting module 1530 is formed on the optical path.

Preferably, the case 1510 includes material having a superior heat dissipation property. For instance, the case 1510 includes metallic material or resin material.

The light emitting module 1530 may include a substrate 1532 and light emitting device packages 100 according to the present invention installed on the substrate 1532. The light emitting device packages 100 are spaced apart from each other or arranged in the form of a matrix.

The substrate 1532 may include an insulating member printed with a circuit pattern. For instance, the substrate 1532 includes a PCB, an MCPCB, an FPCB, a ceramic PCB, and an FR-4 substrate.

In addition, the substrate 1532 may include material that effectively reflects the light. A coating layer can be formed on the surface of the substrate 1532. At this time, the coating layer has a white color or a silver color to effectively reflect the light.

At least one light emitting device package 100 is installed on the substrate 1532. Each light emitting device package 100 may include at least one LED (light emitting diode) chip. The LED chip may include an LED that emits the light of visible ray band having red, green, blue or white color and a UV (ultraviolet) LED that emits UV light.

The light emitting device packages 100 of the light emitting module 1530 may be variously arranged to provide various colors and brightness. For example, the white LED, the red LED and the green LED can be arranged to achieve the high color rendering index (CRI).

The connection terminal 1520 is electrically connected to the light emitting module 1530 to supply power to the light emitting module 1530. The connection terminal 1520 has a shape of a socket screw-coupled with the external power source, but the present invention is not limited thereto. For example, the connection terminal 1520 can be prepared in the form of a pin inserted into the external power source or connected to the external power source through a wire.

Any reference in this specification to "one present invention," "an present invention," "example present invention," etc., means that a particular feature, structure, or characteristic described in connection with the present invention is included in at least one present invention of the invention. The appearances of such phrases in various places in the specification are not necessarily all referring to the same present invention. Further, when a particular feature, structure, or characteristic is described in connection with any present invention, it is submitted that it is within the purview of one skilled in the art to effects such feature, structure, or characteristic in connection with other ones of the present inventions.

Although present inventions have been described with reference to a number of illustrative present inventions thereof, it should be understood that numerous other modifications and present inventions can be devised by those skilled in the art that will fall within the spirit and scope of the principles of this disclosure. More particularly, various variations and modifications are possible in the component parts and/or arrangements of the subj ect combination arrangement within the scope of the disclosure, the drawings and the appended claims. In addition to variations and modifications in the component parts and/or arrangements, alternative uses will also be apparent to those skilled in the art.

## Claims

**1.** A light emitting device package comprising:
a body including a cavity;
at least one light emitting device in the cavity;
a resin member filled in the cavity while covering the light emitting device; and
a reflective layer on a lateral side of the cavity except for an upper region of the lateral side of the cavity.

**2.** The light emitting device package according to claim 1, wherein the reflective layer open the body such that the body directly adheres to the resin member at the upper region of the lateral side of the cavity.

**3.** The light emitting device package according to claim 1, wherein the reflective layer is spaced apart from a bottom surface of the cavity.

**4.** The light emitting device package according to any one of claims 1 to 3, further comprising first and second electrodes spaced apart from each other in the cavity.

**5.** The light emitting device package according to claim 4, wherein the reflective layer is electrically isolated from the first and second electrodes.

**6.** The light emitting device package according to claim 4, wherein the light emitting device package includes a plurality of light emitting devices, and each light emitting device is disposed on at least one of the first and second electrodes.

**7.** The light emitting device package according to any one of claims 1 to 3, wherein the reflective layer includes a seed layer on the lateral side of the cavity, and a silver-plated layer on the seed layer.

**8.** The light emitting device package according to claim 7, wherein the silver-plated layer is disposed on a surface thereof with a protrusion.

**9.** The light emitting device package according to claim 7, wherein the seed layer includes at least one selected from the group consisting of Ti, Cu, Ni and Au.

**6.** The light emitting device package according to claim 4, wherein the light emitting device package includes a plurality of light emitting devices, and each light emitting device is disposed on at least one of the first and second electrodes.

**10.** The light emitting device package according to any one of claims 1 to 3, wherein the cavity has at least four lateral sides, and
the reflective layer is disposed on the at least two lateral sides of the cavity.

**11.** The light emitting device package according to claim 10, wherein the reflective layer is disposed on the fourth lateral sides of the cavity.

**12.** The light emitting device package according to claim 10, wherein the cavity has two longer lateral sides extending in an arrangement direction of the light emitting device and two shorter lateral sides adjacent to the two longer lateral sides, and the reflective layer is disposed on the longer lateral sides.

**13.** The light emitting device package according to any one of claims 1 to 2, wherein the body includes
a silicon member, and
an insulating layer covering the silicon member.

**14.** The light emitting device package according to any one of claims 1 to 3, wherein the reflective layer has a height higher than a height of the light emitting device.

**15.** A lighting system comprising:
a light emitting device package according to any one of claims 1 to 14.
